# FASCICULE DE BREVET EUROPEEN

(11) **EP 1 052 736 B1**
(45) Date de publication et mention de la délivrance du brevet: **11.06.2003**
(21) Numéro de dépôt: 00401185.4
(22) Date de dépôt: 28.04.2000
(51) Int. Cl.: H01R 13/629, H01R 12/28

(54) **Composant électrique à nappe souple de conducteurs de raccordement**
Elektrisches Verbindersystem für Flachkabel
Electrical connecting system for flat cable

(30) Priorité: 07.05.1999 FR 9905825
(43) Date de publication de la demande: 15.11.2000
(73) Titulaire: SAGEM SA, 75116 Paris (FR)
(72) Inventeur: Lequenne, Yves, 92500 Reuil Malmaison (FR)
(74) Mandataire: Bloch, Gérard

(56) Documents cités:
- WO-A-94/07318
- US-A- 5 304 987
- US-A- 5 526 217

## Description

L'invention concerne les films ou circuits souples de conducteurs électriques en nappe servant à relier deux cartes de circuit imprimé ou autres composants électriques d'un appareil et, plus précisément un composant électrique pourvu d'une nappe souple de conducteurs de liaison comportant deux conducteurs de test de continuité raccordés par le composant.

La souplesse de la nappe permet, lors d'une manipulation, de déplacer les cartes qui y sont raccordées.

Chaque extrémité de conducteur de la nappe est reliée électriquement à une piste de carte ou une borne de connecteur, en général par soudage. Afin d'éviter que ces soudures, relativement fragiles; soient arrachées par inadvertance, la zone d'extrémité de la nappe de conducteurs est fixée, par exemple collée à plat sur la carte. Les soudures ne servent donc pas de fixation mécanique.

Cependant, lors d'une manipulation, il n'est pas exclu que le technicien tire par inadvertance sur la nappe et la déchire ou la décolle, en tout ou partie, de la carte. En pareil cas, les soudures perdent la protection mécanique que leur apportait le collage de la nappe et elles risquent d'être détruites par arrachement.

Le défaut de fonctionnement qui va en résulter sera éventuellement détecté par le technicien, qui devra tenter de réparer les pistes arrachées et d'y souder à nouveau les conducteurs. Fait encore plus grave, il peut même se produire que quelques conducteurs soient arrachés des pistes mais restent en contact avec celles-ci du fait que la nappe est encore maintenue en place par les autres conducteurs. De ce fait, le défaut de fonctionnement n'apparaîtra que plus tard, en cas de vibrations, et sera très difficile à localiser.

WO 94/07318 propose un composant du type défini ci-dessus. Cependant, le problème présenté dans ce document est de détecter la présence de la nappe sur le composant associé à celui duquel la nappe est solidaire et non pas de détecter une coupure.

Ainsi, l'invention concerne un composant du type défini ci-dessus, caractérisé par le fait que les conducteurs de test s'étendent le long des bords de la nappe.

Tout d'abord, si la nappe de conducteurs est déchirée, le raccordement des conducteurs de test est rompu et la déchirure ainsi détectée. Mais surtout, même si la nappe n'est pas entièrement détériorée, on détecte quand même un défaut.

Avantageusement, le composant porte une piste de raccordement des conducteurs de test de la nappe.

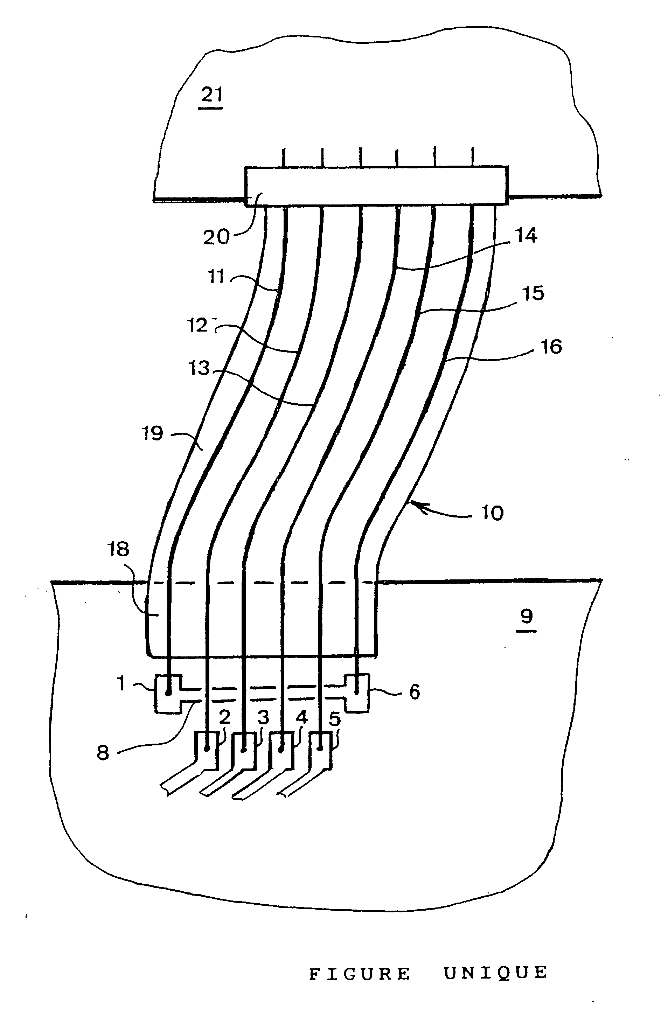

L'invention sera mieux comprise à l'aide de la description suivante d'une forme de réalisation préférée du composant électrique de l'invention, en référence à la figure unique annexée qui représente un film souple de conducteurs collé sur le composant de l'invention et relié à un connecteur.

Sur la figure, le composant de l'invention est une carte 9 de circuit imprimé pourvue d'une nappe souple 10 de conducteurs électriques 11-16 à laquelle elle est reliée mécaniquement et électriquement. Il s'agit ici de pistes conductrices imprimées sur un film en polyester 19.

La nappe 10 est plane au repos mais elle peut naturellement se déformer. Elle est ici raccordée, à son extrémité opposée à la carte 9, à un connecteur 20 destiné à recevoir une autre carte de circuit imprimé 21 portant des circuits électriques. Le raccordement mécanique au connecteur 20 est effectué par collage à celui-ci ou par pincement de la nappe 10 dans celui-ci.

La carte 9 comporte six plages de soudage 1 à 6 sur lesquelles sont soudées les extrémités des pistes respectives 11 à 16. Dans cet exemple, les pistes latérales 11 et 16 sont plus courtes que les pistes centrales 12 à 15. De ce fait, une zone d'extrémité 18 de la nappe 10 étant collée à plat sur une zone, ici latérale, de la carte 9, les plages centrales 2 à 5 sont reliées au connecteur 20 par les pistes centrales 12-15 plus longues que les pistes latérales 11 et 16 situées près des bords latéraux respectifs de la nappe 10.

## Revendications

1. Composant électrique pourvu d'une nappe souple (10) de conducteurs de liaison (11-16) comportant deux conducteurs (11, 16) de test de continuité raccordés par le composant, **caractérisé par le fait que** les conducteurs de test (11, 16) s'étendent le long des bords de la nappe (10).

2. Composant selon la revendication 1, dans lequel le composant porte une piste (8) de raccordement des conducteurs de test (11, 16) de la nappe (10).

3. Composant selon l'une des revendications 1 et 2, dans lequel la nappe (10) comporte quatre conducteurs de test en série avec des organes de test.

## Claims

1. Electrical component provided with a flexible ribbon (10) of linking conductors (11-16) which includes two continuity test conductors (11, 16) connected by the component, **characterized in that** the test conductors (11, 16) extend along the edges of the ribbon (10).

2. Component according to Claim 1, in which the component carries a track (8) for connection of the test conductors (11, 16) of the ribbon (10).

3. Component according to either of Claims 1 and 2, in which the ribbon (10) includes four test conductors in series with test members.

## Patentansprüche

1. Elektrisches Bauteil, das mit einem flexiblen Band (10) aus Verbindungsleitern (11 - 16) versehen ist, die zwei Durchgangsprüfleiter (11, 16) umfassen, welche durch das Bauteil verbunden sind, **dadurch gekennzeichnet, dass** sich die Prüfleiter (11, 16) entlang den Rändern des Bands (10) erstrecken.

2. Bauteil nach Anspruch 1, das eine Bahn (8) zur Verbindung der Prüfleiter (11, 16) des Bands (10) aufweist.

3. Bauteil nach einem der Ansprüche 1 und 2, bei dem das Band (10) vier Prüfleiter umfasst, die mit den Prüfgliedern in Reihe geschaltet sind.
